# EUROPÄISCHE PATENTANMELDUNG

(11) **EP 2 088 532 A1**
(43) Veröffentlichungstag der Anmeldung: **12.08.2009**
(21) Anmeldenummer: 08075863.4
(22) Anmeldetag: 04.11.2008
(51) Int. Cl.: G06K 7/08, H05K 3/12

(54) **Flächiger Datenträger**

(30) Priorität: 06.02.2008 EP 08075094; 06.02.2008 EP 08075095; 19.05.2008 DE 102008024733; 15.10.2008 EP 08075828
(71) Anmelder: Voigt, Sascha, 09337 Bernsdorf (DE); Thiele, Jan, 09111 Chemnitz (DE)
(72) Erfinder: Kreutzer, André, 09648 Mittweida (DE); Thiele, Jan, 09111 Chemnitz (DE); Voigt, Sascha, 09337 Bernsdorf (DE)
(74) Vertreter: Boeckh, Tobias

(57) **Zusammenfassung**

Die Erfindung betrifft einen Datenträger, der die eindeutige und eineindeutige Zuordnung von Informationen zulässt, die Verwendung dieses Datenträgers sowie ein Datenverarbeitungssystem, bei dem ein Datenträger über die Struktur einer Datei eines Speichers zugeordnet werden kann. Insbesondere betrifft die Erfindung auch ein Spielkartensystem, welches die eineindeutige Zuordnung von Spielern und anderen spielrelevanten Daten ermöglicht, wobei das System aus Spielkarten Sammelkarten umfasst, die online wie auch offline eingesetzt werden können; demgemäß betrifft die Erfindung in einer besonders bevorzugten Ausführungsform auch die Verbindung des klassischen Sammelkartenspiels mit Computer- und Videospielen. Besonders bevorzugt betrifft die Erfindung daher Sammel-/Spielkarten, die Datenträger darstellen und einen durch ein Lesegerät auslesbaren, eindeutigen und eineindeutigen Code aufweisen.

## Beschreibung

Die Erfindung betrifft einen Datenträger, der die eindeutige und eineindeutige Zuordnung von Informationen zulässt, die Verwendung dieses Datenträgers sowie ein Datenverarbeitungssystem, bei dem ein Datenträger über die Struktur einer Datei eines Speichers zugeordnet werden kann. Insbesondere betrifft die Erfindung auch ein Spielkartensystem, welches die eineindeutige Zuordnung von Spielern und anderen spielrelevanten Daten ermöglicht, wobei das System aus Spielkarten Sammelkarten umfasst, die online wie auch offline eingesetzt werden können; demgemäß betrifft die Erfindung in einer besonders bevorzugten Ausführungsform auch die Verbindung des klassischen Sammelkartenspiels mit Computer- und Videospielen. Besonders bevorzugt betrifft die Erfindung daher Sammel-/Spielkarten, die Datenträger darstellen und einen durch ein Lesegerät auslesbaren, eindeutigen und eineindeutigen Code aufweisen.

Im Stand der Technik sind verschiedene, vor allem flächige Druckmaterialien bzw. Datenträger bekannt, die mittels verschiedener Beschichtungsverfahren hergestellt werden können. So offenbart die EP 1 803 562 ein Verfahren zum Transfer von bildgebenden oder ab- bzw. überdeckenden Schichten von einer Trägerfolie auf Druckbogen in einer bogenverarbeitenden Maschine, wenigstens mit einem Auftragswerk für eine bildmäßige oder flächige Beschichtung eines Druckbogens mit einem Kleber und wenigstens einem Beschichtungswerk zum Übertragen bildgebender oder abdeckender Schichten von der Trägerfolie auf den Druckbogen, wobei in einem Beschichtungswerk ein Transferspalt gebildet und die Trägerfolie an der Oberfläche einer Presswalze entlang mit einer beschichteten Seite auf einem Druckbogen aufgelegt und unter Druck gemeinsam mit diesem durch den Transferspalt führbar ist, so dass die bildgebenden oder abdeckenden Schichten in mit Kleber versehenen Bereichen von der Trägerfolie auf den Druckbogen haftend übertragen werden, wobei der Druckmaschine Folienbogen zugeführt werden, die auf wenigstens einer bedruckten oder beschichteten bzw. unbedruckten oder unbeschichteten ersten Seite in einem Transferspalt mit einer bildmäßigen oder vollflächigen Folienbeschichtung von der Trägerfolie versehen werden, wobei die Folienbogen vor und/oder nach der Aufbringung der Folienbeschichtung getrocknet werden.

Die DE 20 2006 013 070 U1 offenbart Verfahren und Mittel zur Erzeugung von Strukturen aus Funktionsmaterialen, die beispielsweise für Spielkarten angewendet werden können, wobei die Spielkarten eine Code-Anordnung aufweisen, die durch einen Computer visualisiert werden können. In der Schrift DE 10 2008 013 509 A1 wird ein steganografisches Verfahren dargestellt, welches mittels Transferfolientechnik Sicherheitsmerkmale in Druckprodukten erzeugen kann. Die Verifikation der Merkmale erfolgt optisch mittels Dekoder. Weiterhin ist ein Sicherheitsmerkmal aus DE102006031795A1 bekannt, welches mittels Transferfolientechnik erzeugt wurde. In diesem Verfahren werden Widerstände bzw. Widerstandsnetzwerke in Druckprodukte eingebracht welche ein Sicherheitsmerkmal darstellen sollen. Die Verifikation erfolgt kontaktbehaftet mittels eines Lesegeräts, welches die Widerstände nach dem ohmschen Prinzip misst. Ein mittels Transferfolientechnik hergestellter Datenträger nach den Ansprüchen ist derzeit nicht bekannt.

In den US 5,818,019, US 3,719,804, US 4,587,410 und US 2006/0118612 werden unter anderem flächige gedruckte Materialien offenbart, die eine sichere Verifikation oder Validierung von Daten erlauben. Dies kann beispielsweise für Medikamente und ihre Verpackungen, aber auch für Lotterielose sinnvoll sein. Die aufgedruckten Informationen stellen z. B. die Authentifizierung sicher oder dienen der Gültigkeitsprüfung. Auch kapazitiv auslesbare Datenträger sind u. a. aus den Anmeldungen US 3,719,804 (permanenter Informationsspeicher) und US 4,587,410 (Parksystem) bekannt. In US 3,719,804 sind die Herstellmöglichkeiten mittels Drucktechniken wie bspw. Siebdruck, Flexodruck und Tiefdruck aufgeführt. Die Beschreibung bezieht sich auf flüssig prozessierbare Tinten welche sich für Druckprozesse eignen. Die Individualisierung erfolgt mittels Trenntechniken der aufgebrachten Leiterzüge. Das Ausleseverfahren ist stark positionsabhängig und ist mit einer festen Ausleseposition des Datenträgers im Lesegerät verbunden.

In US 4,587,410 ist die Bearbeitung und Veränderbarkeit von kapazitiven Strukturen für ein Parkmeter dargestellt. Mittels mechanischer Einheit wird die kapazitive Struktur im Lesegerät sukzessive verändert und so ihr "innerer Wert" verändert. Eine Individualisierung ist nicht vorgesehen. Das komplette System ist ein autarkes System ohne Interaktion zu anderen Systemen oder einer Datenverarbeitung bzw. Datenspeicherung.

Weiterhin werden in der EP 0 569 520 oder aber in der DE 10 2008 013 509 Verfahren zum Drucken offenbart, bei denen leitfähige Elemente verwendet bzw. aufgedruckt werden, um auf einer zu bedruckenden Fläche Informationen zu implementieren, um so die zu bedruckenden Materialien beispielsweise für Auslesevorrichtungen zu individualisieren. Die mit den offenbarten Verfahren gewonnen Produkte können beispielsweise in der Logistik, beim Postversand oder bei der Warenverfolgung eingesetzt werden.

Die im Stand der Technik vorgeschlagenen Lösungen weisen mehrere Nachteile auf. Sie sind beispielsweise für die Massenanwendung nicht preiswert genug und können aufgrund ihres komplexen Aufbaus nur unvollkommen recycelt werden.

Aufgabe der Erfindung war es daher, einen kostengünstigen und effizienten flächigen Datenträger mit eindeutiger und/oder eineindeutiger Zuordnung bereitzustellen, der einfach ausgelesen und ausgewertet werden kann. Außerdem war es die Aufgabe der Erfindung, die Variabilität des Auslesevorgangs zu verbessern und zu ermöglichen, dass auf dem Datenträger zusätzliche optische und akustische Funktionen realisiert werden können.

Es war völlig überraschend, dass die technische Aufgabe durch Vorrichtungen und Systeme gemäß den unabhängigen Ansprüchen gelöst werden konnte, wobei sich vorteilhafte Ausführungsformen dieser aus den Unteransprüchen ergeben. Zur Lösung der o. g. Aufgabe wird demgemäß erfindungsgemäß vorgeschlagen, einen Datenträger, insbesondere einen flächigen Datenträger bereitzustellen, bei dem auf einem elektrisch nicht leitenden Substrat eine Kleberschicht aufgebracht wird, auf die wiederum eine strukturierte Informationsschicht folgt, die insbesondere aus Metallen, Graphit, Ruß, dielektrischen Werkstoffen oder anderen, dem Fachmann bekannten Materialien gebildet werden kann, wobei wenigstens eine zumindest den Bereich des Substrats mit der strukturierten Informationsschicht überdeckenden weiteren Schicht angeordnet ist, die beispielsweise eine Papierschicht und/oder eine Farbschicht sein kann, wobei die genannte Informationsschicht eine aufgebrachte Transferschicht ist und mindestens ein Bereich der strukturierten Informationsschicht gleichzeitig ein Geber für eine kapazitive Leserichtung ist. Die erfindungsgemäße Lehre stellt demgemäß eine Kombinationserfindung zum technischen Handeln dar, bei der mehrere Elemente zur Erreichung eines technischen Gesamterfolges zusammenwirken. Es war überraschend, dass die Kombination der beanspruchten Elemente zu einem Datenträger mit überraschenden Eigenschaften führt. Die im Datenträger vereinigten Elemente wirken auf das einheitliche Ziel der Lösung der erfindungsgemäßen Aufgabe hin, da sie sich gegenseitig beeinflussen, ergänzen und dadurch den überraschenden Gesamterfolg der Erfindung herbeiführen. Der einheitliche technische Erfolg, der auf den Wirkungen der einzelnen, insbesondere in den flächigen Datenträgern zusammengeführten Elemente beruht, ist die Klammer der erfindungsgemäßen Kombination. Auch wenn einzelne Teile der Kombination im Stand der Technik beschrieben waren, ist ihre Verbindung im Stand der Technik nicht beschrieben und auch nicht nahegelegt. Es war für den durchschnittlichen Fachmann völlig überraschend, dass die beanspruchten Elemente funktionell so zusammenwirken können, dass beispielsweise ein Datenträger mit einem eindeutigen oder eineindeutigen Code bereitgestellt werden kann. Der Stand der Technik gab dem Durchschnittsfachmann keine Anregung, in einem Datenträger die Elemente eines elektrisch nicht leitenden Substrats, bevorzugt eine Kleberschicht, eine strukturierte, mindestens einlagige Informationsschicht und wenigstens eine zumindest einen Bereich des Substrates mit der strukturierten Informationsschicht überdeckenden weiteren Schicht anzuordnen, wobei die Informationsschicht eine aufgebrachte Transferschicht und mindestens ein Bereich der strukturierten Informationsschicht gleichzeitig ein Geber für eine kapazitive Leseeinrichtung ist. Als Geber werden erfindungsgemäß bevorzugt Bereiche der Informationsschicht verstanden, in welchen das Material der Transferschicht auf dem Substrat vorliegt. Die Summe der Geber bildet die Informationsschicht. Mittels kapazitiver Kopplung mit dem Lesegerät werden diese Bereiche als andersartig im Vergleich zum nichtleitenden Substrat erkannt und können die durch das Lesegerät eingebrachten Signale reflektieren und / oder elektrisch weiterleiten.

Erfindungsgemäß erfolgt die Strukturierung der Information des Datenträgers insbesondere über den Kleber. Eine bevorzugte Variante sieht vor, diesen strukturierten Kleber direkt auf ein Substrat (Bedruckstoff) aufzubringen und anschließend in Kontakt mit einer Transferfolie zu führen. Die Transferfolie selbst besteht aus mindestens zwei Schichten, einer transferierbaren Schicht (=Transferschicht) bzw. einem transferierbaren Medium zur Informationsabbildung und einem weiteren Trägermaterial, welches diese Schicht / dieses Medium trägt. Die Verbindung der zwei Schichten ist so ausgebildet, dass ein Übertrag der Transferschicht gut möglich ist, demnach also das Adhäsionsvermögen des strukturierten Klebers höher sein muss als das Kohäsionsvermögen der Transferschicht und das Adhäsionsvermögen auf dem Trägermaterial der Transferschicht. In einer weiteren bevorzugten Ausführungsform der Erfindung kann der strukturierte Kleber direkt auf die Transferfolie aufgebracht werden und in Kontakt mit einem Trägermaterial gebracht werden. Dies kann zudem durch Zuhilfenahme von Druck, Temperatur, mechanischen Hilfsmitteln wie Prägestempel, Kontaktpressungen etc. unterstützt werden. Die so auf den Bedruckstoff übertragene Schicht ist als Transferschicht zu verstehen, da durch den Kleber zumindest partiell eine stoffschlüssige Verbindung geschaffen wird und diese zum Trägermaterial stärker ausgebildet ist, als der innere Zusammenhalt der Schicht auf der Transferfolie selbst. Vorteilhafter Weise können sowohl der Kleberauftrag als auch das Zusammenfahren des Trägermaterials mit der Transferfolie in einer Maschine erfolgen. Ist der Materialübertrag erfolgt, enthält das Trägermaterial sowohl den strukturierten Kleber als auch diesen gleichermaßen deckend das Transfermaterial, welches nun ebenfalls strukturiert ist. Dieses strukturierte Transfermaterial auf dem Bedruckstoff bezeichnet man als Informationsschicht, weil aufgrund ihres Layouts und der materiellen Eigenschaften des Transfermaterials eine kapazitive auslesbare Struktur ergeben, welche in einem geeigneten Lesegerät bestimmt werden kann. Die Informationsschicht stellt somit den Dateninhalt des Datenträgers dar.

Eine kapazitive Leseeinrichtung dient zu Decodierung bzw. Zum Auslesen der aufgebrachten Informationsschicht. Dabei sind die aktiven Flächen des Lesegerätes (=Lesegerätelektroden und/oder Kondensatorflächen) so ausgebildet, dass die Informationen des Datenträgers zweifelsfrei ausgelesen werden können.

Erfindungsgemäß bildet der Datenträger im Auslesevorgang einen Bestandteil der Leseeinrichtung bzw. einen Bestandteil mit den Anordnungen der Lesegerätelektroden des Lesegeräts . Erfindungsgemäß ist die Leseeinrichtung mit dem Datenträger mit einer Datenverarbeitungseinheit so zusammengeschaltet, dass der Datenträger über die Struktur einer Datei eines Speichers zugeordnet werden kann.

Weitere Elemente können auf dem Datenträger vorgesehen sein, welche dem Lesegerät die Lagebestimmung relativ zum Datenträger ermöglicht. Damit ist ein positionsunabhängiges Ausleseverfahren realisiert.

Die vorgeschlagene Erfindung grenzt sich somit zu bereits bekannten Mitteln oder Verfahren zur Erzeugung kapazitiver Strukturen ab, als auch in der Verwendung dieser. Weiterhin ist ein hoher Ökonomisierungsgrad sowie erstmalig die Möglichkeit zur Herstellung einzigartiger Datenträger mittels Massenproduktionsverfahren welches zudem die optische Veredlung des Produktes in einer Maschine löst. Damit werden Datenträger ohne Zeitverlust oder Sondermaschinen in bereits existierende Produkte aufgebracht, z. B. Verpackungen und können in diesen entweder zur Produktsicherung und/oder Verkaufssteigerung benutzt werden. Produktsicherungen mittels RFID Etikett im ID1 Format kosten je nach Menge üblicherweise zwischen 5 und 25cent, müssen separat hergestellt und auf die Verpackungen appliziert werden. Mit der vorgeschlagenen Erfindung wird sowohl die Anbringung am Produkt gelöst, als auch die Verwendung verschiedener und verschieden zu entsorgender Materialien obsolet. Zudem reduziert sich der Preis im vorgegebenen Beispiel auf 20% - 4% der RFID Kosten.

Bevorzugt ist das elektrisch nicht leitende Substrat ein Trägermedium, welches beispielsweise Papier, Karton, Holz, Gummi oder Glas oder aber ein Kunststoff sein können, insbesondere PET, ABS, PC und andere. Besonders bevorzugt ist das Trägermedium Papier, Karton oder ein Kunststoff. Besonders bevorzugt wird das Papier aus Zellstoff oder Holzstoff aus Holzschliff hergestellt. Das Papier kann beispielsweise in Form von Pappe oder Karton vorliegen. Pappe im Sinne der Erfindung ist ein aus Zellstoff oder Altpapier durch Zusammenkleben oder Zusammenpressen gefertigter Werkstoff. Bei dem Karton kann es sich um ein aus ein oder drei oder mehr Lagen zusammengeklebten Papierkörper handeln, bei dem die Deckschichten und die mittleren Einlagen eine gleiche oder unterschiedliche Zusammensetzung aufweisen, indem beispielsweise die Deckschichten aus holzfreien Stoffen hergestellt und die mittleren Einlagen aus holzhaltigen Stoffen bereitgestellt werden. Ein weiteres bevorzugtes Trägermedium ist Kunststoff. Bevorzugt kann es sich um Polyethylen, Polypropylen, Polyvinylchlorid, Polystyrol, Polycarbonat, Polyurethan, PVDF, Polyethylenterephthalat oder Co-polymeren der Vorgenannten handeln. Die Informationsschicht bzw. die informationsabbildende Schicht können bevorzugt Metalle oder metallhaltige Stoffe sein, wie z. B. Kaltfolien mit einer Aluminium- oder anderen Transferschichten oder aber auch die bereits genannten dielektrischen Materialien oder aber Graphit und Ruß. Besonders bevorzugt sind Metalle oder metallhaltige Stoffe, da diese eine gute elektrische Leitfähigkeit, aber auch eine gute thermische Leitfähigkeit, wie auch eine sehr gute Verformbarkeit aufweisen. Die elektrische Leitfähigkeit kann im Sinne der Erfindung auch als Konduktivität bezeichnet werden. Bevorzugte Metalle oder metallhaltige Stoffe umfassen Aluminium, Blei, Eisen, Gold, Kupfer, Magnesium, Wolfram, Zink oder Zinn. Selbstverständlich ist es auch möglich, dass die Metalle oder die metallhaltigen Stoffe Elemente wie Chrom, Molybdän oder andere umfassen. Dielektrische Materialien im Sinne der Erfindung ist jede elektrisch schwach oder nicht leitende, nicht metallische Substanz, deren Ladungsträger im Allgemeinen frei beweglich sind. Es kann sich hierbei um Keramikwerkstoffe oder auch Kunststoffe wie Polyethylen handeln. Besonders bevorzugt ist es, wenn die Informationsschicht mit der Kaltfolientechnik bzw. Kaltfolienveredelung auf das nicht leitende Substrat des Trägermediums aufgebracht werden kann. Selbstverständlich ist es auch möglich, statt der Kaltfolientechnik Verfahren mittels Heißfolien-Prägemaschinen oder ähnlichem einzusetzen. Die erfindungsgemäßen Datenträger können mit verschiedenen Prägetechniken wie dem Heißfolienprägen und dem Prägedruck erzeugt werden. Aber auch alle anderen dem Fachmann bekannten Druckverfahren im Bereich des Hochdrucks, Flachdrucks, Tiefdrucks, Durchdrucks oder andere können verwendet werden. Selbstverständlich ist es auch möglich, elektronische Druckverfahren wie Matrixdruckverfahren, Elektrodruckverfahren, Elektrolytdruckverfahren oder andere zumindest teilweise für die Herstellung der erfindungsgemäßen Datenträger zu verwenden. Besonders bevorzugt ist allerdings die Kaltfolientechnik. Es war völlig überraschend, dass mithilfe der Kaltfolientechnik sehr effizient kapazitiv auslesbare Datenträger zur Verfügung gestellt werden können.

Als Kleber konnten sowohl permanent als auch temporär klebende Vertreter benutzt werden. Sowohl wässrige als auch lösemittelhaltige Kleber eigneten sich zur Strukturierung und zum lokalen Herauslösen der Transferschicht als auch physikalisch oder chemische abbinde Kleber. Der Begriff Kleber umfasst dabei auch klebrige Materialien echten organischen Ursprungs welche der Fachmann als Leime bezeichnet. Jedes geeignete Mittel mit Anhaftungsbestrebungen zur Transferfolie ist geeignet, besonders bevorzugt physikalisch abbindende Kleber für Offsetdruckmaschinen. Die physikalischen Effekte umfassen bevorzugt Temperatur, aber auch Lichtquellen wie beispielsweise UV-Licht.

Besonders bevorzugt ist es, einen strukturierten Kleber auf ein elektrisch nicht leitendes Substrat aufzubringen. Die Strukturierung und Aufbringung von Klebern ist technisch sehr leicht möglich im Gegensatz zum zumindest partiellen Entfernen von Strukturen aus einem vollflächigen Material. Dies geschieht meist durch nasschemische Prozesse wie Ätzen und ist daher von der Substratauswahl und vom aufzubringenden Medium sehr begrenzt und daher nachteilig. Die Strukturierung des Klebers hat weiterhin die Vorteile sehr flexibel Layoutwechsel oder Änderungen der Datenstruktur vorzunehmen. Dies ist in einer besonders bevorzugten Variante des Offsetdruckes das Auswechseln einer Offsetplatte bzw. eines Gummituchs.

In einer weiteren bevorzugten Ausführungsform wird der Kleber zuerst auf die Transferfolie aufgebracht und anschließend diese zumindest partiell klebende Transferfolie mit dem Substrat in Kontakt gebracht. Geeignete Verfahren zur Kleberaufbringung sind bevorzugt Flach- , Hoch-, Tief- und Sonderdruckverfahren. Besonders bevorzugt Offsetdruck- und Inkjetverfahren.

Als strukturiert soll erfindungsgemäß das flächige Layout bzw. Gestaltung der Datenträger verstanden sein, welche mit dem dazugehörigen Leseprinzip und -gerät erfasst und gelesen werden können.

Dabei bildet das System Datenträger- Lesegerät eine sinnvolle Einheit. In einer besonders bevorzugten Ausführungsform ist die Lesefläche des Lesegerätes mindestens gleich groß wie der Datenträger (die folgenden Figuren illustrieren dies).

Der Datenträger, insbesondere in seinen genannten bevorzugten Ausführungsformen, weist folgende Vorteile auf:
- preiswerter Datenträger und preiswerte Leseeinrichtung (im Gegensatz zu RFID Lösungen und optischen Lösungen)
- sehr gut recycle fähig (im Gegensatz zu beispielsweise. Chipkarten, welche einen Multi-Materialverbund darstellen)
- physiologisch unbedenklich (wichtig vor allem im Einsatz von Kinderspielzeug)
- Herstellung der Datenträger sowohl im Rolle-zu-Rolle Verfahren als auch im Bogen Verfahren
- individualisierbar (eindeutige Zuordnung, als auch eineindeutige Zuordnung möglich) (im Gegensatz zu RFID Funktionspolymeren oder anderen kapazitiven Datenträgern)
- direkte Produkt-/Verpackungsintegration möglich
- Verfahrenskompatibilität (alles reine Druckprozesse)
- kontaktlose Datenübertragung (im Gegensatz zu kontaktbehafteten Chipkarten)
- Robustheit (z.B. unsensibel gegenüber Verschmutzungen, da nicht optisch (im Gegensatz zu Barcode / 2D-Barcode; flexible und starre Ausführung möglich)
- Sicherheit (Informationen von Magnetkarten und RFID Lösungen können geändert oder zerstört werden)
- Kopierschutz (Informationen auf (2D-)Barcodes können sehr leicht kopiert werden )
- Breite Materialauswahl seitens der Substrate als auch der Materialien für die Informationsschicht
- Mehrfachverwendbarkeit ist gegeben (die reale Karte behält ihre Gültigkeit, auch wenn sie bereits in einem datenverarbeitenden System benutzt wurde; im Gegensatz dazu beispielsweise eineindeutige alphanumerische Codes auf Spielkarten, welche sichtbar aufgedruckt sind und wertlos werden, wenn der Code einmal eingegeben wurde, da der Code im System als benutzt gespeichert wird. Die Karte kann somit auch nicht mehr getauscht werden, da der Zahlencode entwertet wurde)
   Mit den nicht sichtbaren Datenträgern dieser Erfindung ist der verarbeitbare Code stets mit der physischen Anwesenheit der Karte verbunden, die Karte behält ihre Gültigkeit und kann immer oder mehrmals benutzt werden. Die Karten bleiben somit tausch- und handelbar.

In US 3,719,804 und US 4,587,410 Datenträger bekannt welche in ein Lesegerät eingeführt werden müssen und das Lesegerät selbst Anschläge und Führungen besitzt um die korrekte Lage des Datenträgers sicherzustellen. Die hier erfindungsgemäßen Datenträger sind auch mit dieser Art von Lesegeräten auslesbar, aber nicht auf diese limitiert. Die erfindungsgemäßen Datenträger erlauben zudem in bevorzugten Ausführungen das Auflegen oder Anhalten des Datenträgers auf eine Lesegeräteoberfläche. Dies ist eine wichtige Verbesserung zum Stand der Technik, weil gerade Einschiebe- und Einfädelprozesse Zeit kosten und beispielsweise den Spielfluss von den erfindungsgemäß vorgeschlagenen Sammelkartenspielen behindern. Zudem ist es zum derzeitigen Stand der Technik vorteilhaft die Datenträger durch beabsichtigte oder unbeabsichtigte Fehlpositionierung sicher auslesen zu können. Papier und andere weiche Materialien zeigen zudem Verschleißerscheinungen und weisen nach mehrmaligem Benutzen Eselsohren, Papierspliss oder wellige Ränder auf, welche einen Auslesevorgang vor allem in Lesegeräten mit Schlitz erschweren. Diese Hindernisse sind damit erfindungsgemäß gelöst. In weiteren bevorzugten Ausführungen kann der Datenträger zumindest partiell aber auch am Lesegerät durchgezogen oder durchgeschoben werden. In einer weiteren bevorzugten Ausführungsform wird der Datenträger wahllos auf oder an einer Lesegerätoberfläche platziert. Das Lesegerät ist durch die Ausführung der Lesegeräteoberfläche (vgl. Fig 2, Fig 4, 8.) in der Lage den Code fehlerfrei auszulesen. Dies geschieht bevorzugt mittels Einbringung sogenannter Sekundärinformationen, welche eine relative Lagebestimmung des Datenträgers zum Lesegerät erlauben. Diese Sekundärinformationen können besonders bevorzugt mit dem gleichen Verfahren wie der Datenträgerinhalt selbst aufgebracht sein. Die Verwendung der Sekundärinformationen zur relativen Lagebestimmung ist bevorzugt, aber nicht allein darauf begrenzt. Besonders bevorzugt ist es, wenn die Leseeinrichtung des Datenverarbeitungssystems einen Schacht, einen Schlitz und/oder eine Auflagefläche zur Aufnahme wenigstens eines Teils des Datenträgers besitzt.

Die zufällige oder vorgegebene Positionierung erfolgt so, dass mit den Anordnungen der Lesegerätelektroden die Information bzw. der Speicherinhalt des Datenträgers ausgelesen werden kann und somit bestimmbar ist. In einer weiteren bevorzugten Ausführungsform sind die Elektroden der Leseeinrichtung so ausgebildet oder angeordnet, dass die Anzahl und/oder Größe und/oder die Form der Bestandteile der Struktur des Datenträgers erfasst werden. So kann man mittels des in Fig 2. Dargestellten Lesegerätes nur 16Bit Datenträger auslesen, weil 16 Lesegerätelektroden vorhanden sind und nur den Zustand 1 (Geber vorhanden) oder 0 (kein Geber vorhanden) annehmen können. Für eine Vielfalt von Anwendungen, insbesondere Sammelkartenspiele ist es notwendig eine höhere Speicherauflösung zu bekommen. Dafür ist erfindungsgemäß die Erzeugung neuartiger Lesegerätoberflächen (Fig 4, Fig 6, Fig 8) sinnvoll, welche nicht dem Bitprinzip folgen sondern integrativen, aufsummierenden und differentiellen Möglichkeiten der Informationsauslesung. Dadurch wird die Dimension der Information nicht ausschließlich auf vorhanden oder nicht vorhandene Geberstrukturen limitiert sondern um relative Lage der Flächen zueinander, relative Größe der Flächen und Verteilung erweitert. In durchgeführten Versuchen sind Informationstiefen von 10^27 für die Größe einer Sammelkarte im ID1-Format erreichbar gewesen.

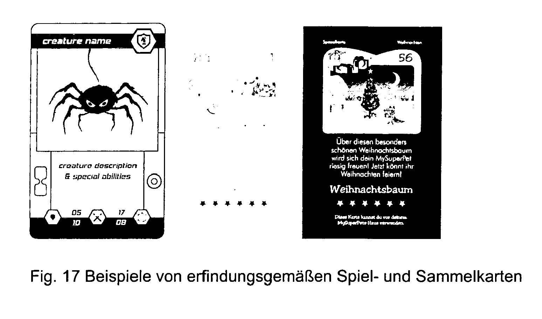

Für zahlreiche der auch im Zusammenhang mit den Ausführungen im Stand der Technik genannten Anwendungen ist es aus Sicherheitsaspekten oder anwendungsbezogenen Gründen (Sammelkartenspiel, Geldtransfer, Zutrittsberechtigungen etc.) notwendig, eine eineindeutige Zuordnung bzw. Identifikation zu realisieren. Mit einer solchen Zuordnung bzw. Identifikation können Gepäckstücke, Waren oder Zahlungsmittel autorisierten Personen bzw. Institutionen zugeordnet werden. Bekannt ist dies im Stand der Technik von den RFID-Tags, die mit sogenannten Unique Identifiers (UID) ausgestattet sind. Die elektronische Datenverarbeitung hinter den Zahlencodes erfolgt fast ausschließlich an zugehörigen Rechnern, Servern und datenverarbeitenden Medien. Dadurch können dem Datenträger im Hintergrund weitere Informationen zugeordnet werden. Bei diesen weiteren Informationen handelt es sich beispielsweise um die letzte Benutzung, den Ort der Benutzung, besondere Vorkommnisse oder im Zusammenhang mit Spielen, insbesondere Spielkarten, um Erfolge bzw. Misserfolge. In einer weiteren bevorzugten Ausführungsform ist vorgesehen, dass wenigstens eine weitere Schicht in Form einer Farbschicht jeweils wenigstens als Hintergrund, Überdeckung, Zahl, Buchstabe, Zeichen, graphische Darstellung, bildliche Darstellung oder als Kombination hiervon aufgebracht ist, wobei mehrere Datenträger eine gleiche Struktur der Informationsschicht und mindestens eine gleich oder ungleich gestaltete Farbschicht besitzen. Vorteilhafterweise lässt sich durch diese vorteilhafte Ausgestaltung des Datenträgers ein sogenannter eindeutiger Datenträger realisieren; d. h. ein Datenträger, der eine eindeutige Zuordnung ermöglicht. Bei der Ausgestaltung der Farbschicht kann es sich im Falle von Spiel- oder Sammelkarten um solche gemäß Fig 17 handeln.

In einer weiteren besonders bevorzugten Ausführungsform ist vorgesehen, dass die wenigsten eine Farbschicht, die jeweils wenigstens als Hintergrund, Überdeckung, Zahl, Buchstabe, Zeichen, graphische Darstellung, bildliche Darstellung oder einer Kombination hiervor aufgebracht ist, bei mehreren Datenträgern eine ungleiche Struktur der Informationsschicht und gleich oder ungleich gestaltete Farbschichten besitzt. Durch einen solchen Datenträger ist eine eineindeutige Zuordnung möglich.

Es sind verschiedene Möglichkeiten zur Gestaltung der Struktur der Informationsschicht möglich. Bevorzugt kann es sich beispielsweise um geometrische Formen wie Rechtecke, Kreise oder einer Kombination hiervon handeln. Aber auch unbestimmte Formen wie sogenannte Freihandformen oder zufällig oder pseudozufällig erzeugte Strukturen können bevorzugt sein. Die Anordnung der einzelnen Positionen, aber auch die Form und Flächen der Strukturen sind mittels Leseeinrichtung feststellbar, so dass die Struktur oder die Form ein Code einer bestimmten Anzahl von Datenträgern ist.

So ist in Fig 1 ein Datenträger dargestellt welcher mit dem zugehörigen Lesegerät Fig 2 ausgelesen werden kann. Im Auslesevorgang zeigt sich die Information nach einem Bitprinzip als 0011111101111110 (links oben nach rechts oben, links unten nach rechts unten). Diese Struktur entspricht genau diesem Code und jede gleiche Struktur würde diesem Code entsprechen. Damit ist eine Gruppe gleicher Datenträger realisiert. In der besonders bevorzugten Ausführung der Erfindung eines Sammelkartenspiels, kann dieser Code bspw. mit einer Datei, einer Software oder Teilen davon verknüpft sein die sich zentral oder dezentral auf einem Datenverarbeitenden Medium befinden. Im Sinne der Erfindung werden für die Darstellung der Informationsstrukturen des Datenträgers besonders bevorzugt Formen erster Ordnung, wie z. B. Rechtecke, Kreise, Quadrate oder Striche verwendet. In einer weiteren bevorzugten Ausführungsform können dafür geometrische Formen zweiter Ordnung verwendet werden, die aus einer Kombination aus Kreisen, Rechtecken, Quadraten oder Strichen gebildet werden können oder aus Differenzen dieser. In einer weiteren Ausführungsform sind auch geometrisch unbestimmte Formen beispielsweise Schriften, Code-Schriften bzw. Kunst- und/oder Phantasieflächen (vgl. Fig. 00) zur Informationsabbildung verwendbar.

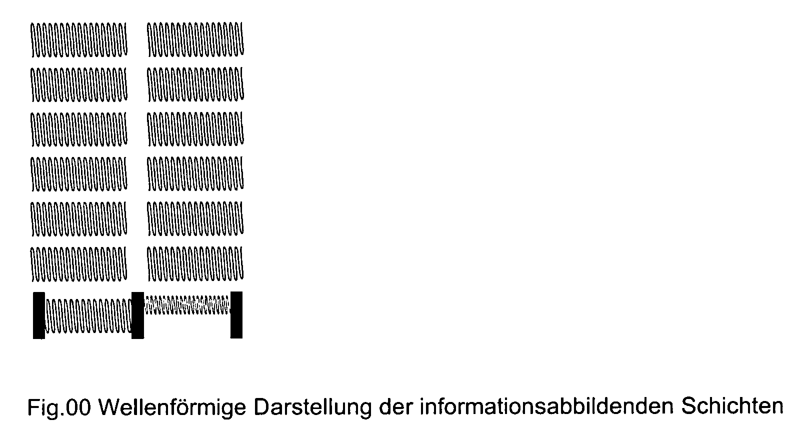

Die erfindungsgemäßen flächigen Datenträger können mit verschiedenen Verfahren gewonnen werden. Bevorzugt sind beispielsweise Verfahren, bei denen die Struktur der Informationsschicht eine additive Struktur oder eine sowohl additiv aufgebrachte als auch subtraktiv veränderte Struktur ist. Die Veränderung, Modifizierung bzw. Aufbringung der genannten Struktur soll so erfolgen, dass das Trägermaterial oder das elektrisch nicht leitende Substrat wenig bis gar nicht beeinträchtigt werden. Ein additives Verfahren im Sinne der Erfindung wäre beispielsweise ein Auftragen der Struktur durch eine Siebdruckmaschine oder aber eine Druckmaschine mit einem Kaltfolientransfermodul. Sofern auf die mit diesen Verfahren erzeugten Informationsstrukturen zusätzlich additiv erzeugte Bereiche aufgebracht werden, ist dies im Sinne der Erfindung eine Kombination aus additiven Verfahren. Selbstverständlich wäre es auch möglich, additive Verfahren wie den Digitaldruck oder aber das Sprüh-, Injekt-, Inkjet-, Stempeldruck-, Präge-, Heißpräge- oder Dispensverfahren zu verwenden. Bei einer Kombination aus einem additiven und einem subtraktiven Verfahren wurden beispielsweise nach Aufbringen mit einem additiven Verfahren im Nachhinein bestimmte Bereich der Informationsstruktur durch beispielsweise Stanzen, Lochen, Schneiden oder aber durch elektrostatische Entladung bzw. Brennen oder Löten gezielt zerstört und somit eineindeutige Codes generiert werden. In den beigefügten Beispielen werden verschiedene Formen der Kombination von additiven Verfahren untereinander wie auch der Kombination von additiven und subtraktiven Verfahren erläutert. Die Herstellung mittels dieser Verfahren erfolgt bevorzugt so, dass aus einem Substrat bzw. einem flächigen Trägermaterial strukturiert Klebstoff und/oder ein Hilfsmittel aufgetragen wird, so dass das Trägermaterial partiell oder vollflächig beschichtet ist. Bei dem Trägermaterial kann es sich um Papier, Karton, einen Holzwerkstoff, einen Verbundwerkstoff, ein Laminat oder einen Kunststoff handeln. Die durch den Klebstoff und/oder das Hilfsmittel gebildete Struktur bildet das Layout für die nächstfolgende Schicht, die sogenannte Informationsschicht. Die Struktur kann bevorzugt weitere Informationen erhalten, die im Sinne der Erfindung als sekundäre Informationen bezeichnet werden, welche die Positionierung, Lage und den Zustand der Karte für das Lesegerät erkennbar machen. Durch direkten Kontakt des beschichteten Trägermaterials mit beispielsweise metallisierter Folie wird eine Anhaftung des metallischen Folienmaterials an den klebenden Stellen erreicht. Selbstverständlich kann es auch vorgesehen sein, dass eine Anhaftung an nicht klebenden Stellen realisiert wird. Klebende Stellen sind im Sinne der Erfindung die Stellen, die mit dem Klebstoff behandelt und somit strukturiert wurden. In einem nächsten Herstellungsschritt erfolgt die Trennung des Trägermaterials vom Informationsmaterial, wodurch ein partiell beschichtetes Trägermaterial erhalten wird. Das so erhaltene Herstellungsprodukt ist ein Datenträger, der in Folgeschritten weiterverarbeitet werden kann. Bei den Folgeschritten handelt es sich bevorzugt um folgende:
- Kaschierung mit Gegenlage (aus den oben genannten Trägermaterialien)
- Kaschierung mit gleichartigem oder ähnlichem Datenträger
- Bedruckung im Flach-, Hoch- oder Tiefdruck zur optischen Veredelung und ggf. optischen Unkenntlichmachung der aufgebrachten Information
- Bedruckung im Flach-, Hoch- oder Tiefdruck zur weiteren Veredlung mit Sicherheits- und/oder Echtheitsmerkmalen (Hologramme, Guillochen, Mikroschrift, weitere Codes etc.)
- Finish-Schichten (Antikratzschichten, (Klar-)Lacke, Spiegelflächen, Rubbelflächen, Entspiegler, Haftvermittler, haptische Schichten (Velours-, Plüsch-, Leder-, Kunststoffhaptik), Geruchsstoffe
- Prägungen (Blindenschrift, Hochprägeschrift, Schönprägungen)
- Aufbringung weiterer Kleberschichten und/oder Transferschichten
- Aufbringung von optischen, elektrischen, sensorischen und/oder akustischen Elementen (beispielsweise Leiterzüge, Feuchte-, Temperatursensoren, Beschleunigungssensoren, Lagesensoren) sowie Energiespeicher und - wandler (beispielsweise Solarzellen, Batterien)
- eine Niveau vermittelnde Schicht, welche gleichzeitig Barriere- und/oder Schirmungsfunktion haben kann

Erfindungsgemäß können mit dem beschriebenen Herstellungsverfahren sowohl eindeutige als auch eineindeutige Datenträger hergestellt werden. Im Falle von eindeutigen Datenträgern heißt das, dass die Informationen des Datenträgers beliebig oft vorkommen und hergestellt werden können (Bsp.: Datenträger A: 00001111, Datenträger 2: 00001111, Datenträger 3: 00001111). Im Auslesevorgang ist also nicht reversibel feststellbar ob Datenträger A, B oder C vorliegt, dennoch ist das Ergebnis feststellbar (00001111) und kann reversibel nur einer Gruppe gleichartiger Datenträger zugeordnet werden, wie hier der Gruppe A, B, C, aber nicht einem einzelnen Element daraus. Weitere Datenträger können wiederum in anderen Gruppengrößen und demnach Häufigkeiten zusammengefasst sein. Wie groß die Gruppen im Einzelnen sind ist dabei völlig egal. Sie können erfindungsgemäß ein bis zu mehrere Millionen oder Milliarden Datenträger umfassen. Bei einem eineindeutigen Datenträger ist jeder Inhalt nur einmal vergeben und demnach ist der Auslesevorgang reversibel, dass heißt anhand des Ergebnisses genau der Datenträger zugeordnet werden kann. In den erfindungsgemäß aufgeführten Verwendungszwecken solcher Datenträger kann sowohl der Bedarf an eindeutigen und/oder eineindeutigen Datenträgern vorhanden sein. Es sind demnach auch Anwendungen denkbar, welche Gruppen gleichartiger als auch nur einmalig vorkommender Datenträger miteinander kombinieren und demnach Häufigkeitsunterschiede vorhanden sind, wie sie beispielsweise in derzeit existierenden Sammelkartenspielen vorkommen.

Um weitere Funktionen realisieren zu können, können mittels geeigneter additiver Verfahren Leiterzüge und elektronische Elemente wie bspw. Batterien, Displays, Sensoren etc. aufgebracht werden. Je nach Element und verwendeten Verfahren empfiehlt sich die Aufbringung vor oder nach Erzeugung der Datenträgerstrukturen. Dabei können die Elemente und deren Beschaltung sowohl separat als auch galvanisch gekoppelt mit den Transferfolienstrukturen vorliegen. Es kann außerdem vorgesehen sein, dass das Substrat im Ausgangszustand der Verarbeitung bereits Elemente oder Teile davon enthält. Bsp.: piezoelektrische Substrate (PVDF-Folien) oder Substrate mit piezoelektrischen Inhaltsstoffen oder Bereichen welche sich zur Realisierung weiterer Funktionen gemäß Anspruch 10 eignen. So können Folien mit piezo-Eigenschaften zur Herstellung von dünnen Lautsprechern verwendet werden.

Die Erfindung betrifft auch ein Datenverarbeitungssystem mit einer Leseeinrichtung und dem erfindungsgemäßen Datenträger, wobei die Leseeinrichtung mehrere Elektroden besitzt und der Datenträger in der Leseeinrichtung ein Bestandteil der Elektrodenanordnung ist und die Leseeinrichtung mit dem Datenspeicher mit einer Datenverarbeitungseinheit so zusammengeschaltet ist, dass der Datenträger über die Struktur einer Datei eines Speichers zugeordnet wird.

Es war überraschend, dass mit dem erfindungsgemäßen Datenverarbeitungssystem im Zusammenhang mit dem erfindungsgemäßen Datenträger beispielsweise eine eineindeutige Zuordnung von Daten möglich ist. Die Datenträger können in die Leseeinrichtung eingeschoben, durchgezogen, durchgeschoben, gezielt aufgelegt oder aber auch ungezielt aufgelegt werden. Dies ist beispielsweise abhängig vom Leseprinzip, von der Anwendung von Kundenwünschen oder Umwelteinflüssen oder aber vom Vorhandensein peripherer Elektronik wie beispielsweise bei Spielautomaten.

In einer besonders bevorzugten Ausführungsform der Erfindung ist die Datei eine Bilddatei entsprechend der gestalteten Farbschicht des Datenträgers.

In einer weiteren bevorzugten Ausführungsvariante ist vorgesehen, dass die Datei ein Schlüssel für ein Datenverarbeitungssystem oder für wenigstens ein mit dem Datenverarbeitungssystem verbundenes, weiteres Datenverarbeitungssystem ist, so dass der Zugang zu weiteren Daten und/oder einer Kommunikation gegeben ist. Im besonders bevorzugten Anwendungsbeispiel des Sammelkartenspiels sind die Datenträger mit autarken, nicht vernetzten Datenverarbeitungssystemen (Handy, Konsole, PC etc.) nutzbar als auch auf vernetzten Datenverarbeitungssystemen. Dabei ist die Vernetzung der Datenverarbeitungssysteme bevorzugt direkt zueinander oder besonders bevorzugt über einen Server bzw. eine andere geeignete Möglichkeit zur Datenverarbeitung bzw. Kommunikation zwischen einzelnen Datenverarbeitungssystemen realisiert. Dabei können die Datenverarbeitungssysteme auch übergreifend miteinander kommunizieren, dass heißt art- und betriebssystemunabhängig.

Die Anzahl der so gleichzeitig vernetzten Systeme ist somit unbegrenzt, mindestens jedoch zwei. In autarken Systemen ist besonders bevorzugt eine Software oder Datenschlüssel hinterlegt oder wird ausgeführt welche/r die Interaktion zwischen Datenträger und Datenverarbeitungssystem realisiert.

Die erfindungsgemäße Lehre bezieht sich nicht nur auf eine Datei als Bezugsziel für einen Datenspeicher; es ist ebenso bevorzugt, dass andere Funktionen, wie beispielsweise ein Eintrag in einer Datenbank ausgelöst werden können, wobei eine Funktion ausgeführt wird, die dateiunabhängig ist. Weiterhin wäre es möglich, den Inhalt zugeordneter Daten aufzurufen und auszuführen, wobei diese Daten beispielsweise Dateien (Bilder, Videos, Texte), Webseiten, Datenbankeinträge (Nutzererkennungen, Spieleigenschaften, Spielgegenstände), Computerprogramme, die gestartet oder beeinflusst werden und/oder die Interaktion dieser technischen Merkmale sein können.

Der erfindungsgemäße Datenträger und das erfindungsgemäße Datenverarbeitungssystem können verschiedenen Verwendungen zugeführt werden und haben demgemäß zahlreiche Einsatzbereich. Hierzu gehören beispielsweise die Anwendungen der Datenträger als Spielkarten oder Sammelkarten, aber auch als Briefmarken (Frankierung oder Porto) innerhalb der Warenlogistik und Warenverfolgung, aber auch für den Einlass bei ausgewählten Veranstaltungen in Form von Eintrittskarten. Hierbei ist es besonders vorteilhaft, dass bestimmte VIP- oder geschlossene Bereiche auch virtuell bestimmt und visualisiert werden können. Vorteilhaft ist auch die Anwendung bei Marketinganwendungen zur Kundenbindung oder als Mitgliederausweis, aber auch zum Payment oder für Signaturen und Echtheitszertifikate. Besonders vorteilhaft ist die Verwendung als Virtual Items oder aber im Downloadbereich für Musik, Video oder E-Books oder aber für Bonusmarken oder entsprechende Programme.

Besonders vorteilhaft ist es, wenn der Datenträger Teil eines Druckproduktes, beispielsweise einer Verpackung ist. Die Verpackung kann beispielsweise für Lebensmittel, Schmuck oder aber im medizinischen Bereich zum Transport von wichtigen Medikamenten oder aber Organen eingesetzt werden. Vorteilhafterweise ist ein Einsatz in allen Bereichen möglich und vorteilhaft, in welchen eine eineindeutige Zuordnung von Informationen erforderlich oder aber vorteilhaft ist.

In einer weiteren bevorzugten Ausführungsform können auf den Datenträger für verschiedene Verwendungen sekundäre Informationen aufgebracht oder enthalten sein. Durch derartige sekundäre Informationen kann z. B. die Orientierung des Datenträgers relativ zur Leseeinrichtung bestimmt werden. Aber selbstverständlich kann es sich bevorzugt auch um Informationen handeln, die weitere übergeordnete Funktionen wahrnehmen, wie z. B. aufgedruckte Werte, Symbole, Zeichen, Sicherheitsmerkmale, wie sie dem Fachmann beispielsweise von Spielkarten oder Sammelkarten bekannt sind. Besonders vorteilhaft ist es, wenn diese Informationen einen virtuellen Wert repräsentieren, der beispielsweise bei einer Spiel- oder Sammelkarte im Laufe ihrer Verwendung konstant ist oder aber ab- bzw. zunimmt.

Am Beispiel einer Sammelkarte soll dargestellt werden wie der virtuelle Wert einer Sammelkarte sich verändern kann oder konstant bleibt. Eine Sammelkarte eines Spiels wird von einem Konsument gekauft. Zu diesem Zeitpunkt besitzt die Karte einen Wert X. Dieser Wert würde sich nicht ändern, wenn die Karte einfach nicht benutzt würde. Wird diese Karte benutzt und bestreitet einen virtuellen Wettkampf, kann sich der virtuelle Wert der Karte je nach Ausgang des Wettkampfes verändern. Im positiven Fall steigt der Wert, im negativen Fall sinkt der Wert. Im Extremfall sinkt der virtuelle Wert reversibel oder irreversibel auf 0, die Karte wird virtuell wertlos. Als Wert soll eine virtuelle Größe verstanden werden der eine Beurteilung der Karte im Sinn des Spiels zulässt. Die Erfassung des virtuellen Wertes kann je nach Datenverarbeitungssystems zentral (PC, Konsole, Handy) gespeichert werden oder auch dezentral in Datenbanken, Serversystem oder vernetzten Datenverarbeitungssystemen. Dieses Beispiel zeigt, dass es sich um Datenträger handelt, welche durch Ihre Zuordnung und Verwendung mit aktiven Medien einen virtuellen Wert erreichen können welcher wiederum den Wert der Karte als Tausch-, Sammel-, Spiel- oder Wertobjekt bestimmt. Im bisherigen Stand der Technik existieren nur Sammelkarten welche einen optisch aufgebrachten Wert besitzen und dieser Wert und die Häufigkeit der Karte selbst den Tausch-, Sammel- oder Spielwert darstellen. Dadurch ähneln bisherige Sammelkartenspiele einer Lotterie in denen man Sammelkarten kauft und nach öffnen der Verpackung die Seltenheit oder den Wert bestimmt hat. Durch die Möglichkeit der virtuellen Wertsteigerung sind Sammelkarten nicht mehr ausschließlich auf solche Merkmale begrenzt. Dies stellt eine drastische Verbesserung zum derzeitigen Stand der Technik dar. Die Verbindung der erfindungsgemäßen Datenträger mit weiteren Funktionen wie sie bereits in herkömmlichen, bekannten Spielkarten existieren, geht aus Anspruch 12 hervor. Zwar ist das optische Kopieren und/oder Nachempfindung mittels Fotokopierer, Scanner und anderer Repromedien in gleichem Maße möglich wie bei herkömmlichen Spielkarten, allerdings wird der Datenträger selbst nicht kopiert und somit die Originalität gewahrt. Dies stellt eine besondere Neuheit zum Stand der Technik dar.

Für Verwendungen wie die bereits genannten, beispielsweise als Spielkarte oder Sammelkarte, Briefmarke, Frankierung, Porto, Warenlogistik, Warenverfolgung, Einlass, Eintrittskarten, Zugang zu geschlossenen Bereichen, virtuellen Inhalten, Marketinganwendung, Kundenbindung, Mitgliederausweise oder Geschenkkarten ist es vorteilhaft, wenn der Datenträger weiter individualisiert oder personalisiert vorliegt. Besonders vorteilhaft kann es sein, wenn der Datenträger nur in Kombination mit einem weiteren Datenträger verwendet werden kann.

In einer weiteren bevorzugten Ausführungsform der Erfindung ist vorgesehen, dass die informationsabbildende Schicht auch das Trägermaterial beinhaltet bzw. das Trägermaterial der informationsabbildenden Schicht gleich dem späteren Trägermaterial des Datenträgers ist.

Im Folgenden soll eine besonders bevorzugte Ausführungsform der Erfindung anhand des Anwendungsbeispiels Sammel-/Spielkarte näher erläutert werden, ohne auf dieses beschränkt zu sein.

Mehrere Konsumenten, z.B. Kinder, kaufen ein Sammelkartenspiel. Diese Sammelkarten sind Datenträger nach dem hier beschriebenen Prinzip mit einem durch ein Lesegerät auslesbaren eindeutigen oder eineindeutigen Code. Dieses Lesegerät ist mit einer Schnittstelle für Computer, Konsole oder Handy ausgestattet. Die Lesegeräte könnten aber auch in bestimmten Umgebungen vorhanden und nutzbar sein, beispielsweise in einer Videothek oder an Spielautomaten.

Bisher haben die Kinder dann nach vorgegebenen oder eigenen Regeln auf dem Schulhof, in der Wohnung oder an sonstigen Plätzen mit ihren Karten gespielt. Dies geschieht durch den Vergleich zum einen der Werte auf den Karten und zum anderen durch die Kombination von mehreren sich ergänzenden Karten. Je nach Regel wird die Karte beim Verlieren aus dem Spiel entfernt oder an den Gegner abgegeben. Zudem können die Karten getauscht oder gehandelt werden. Bislang existiert keine Möglichkeit die realen Karten auf einem PC, auf einer Konsole oder auf ein Handy zu verwenden, um diese dort zu sammeln, zu tauschen oder direkt mit den Karten gegen virtuelle oder reale Gegner zu spielen. Bisher sind die Kinder in regelmäßigen Abständen zu Turnieren gefahren um sich mit anderen zu messen, Karten zu tauschen oder ihre Sammlung zu präsentieren.

Durch das beschriebene System ist es möglich, dass die Kinder ihr Sammelkartenspiel wie bisher auf dem klassischen Weg spielen (durch Vergleich optisch aufgebrachter Werte, Buchstaben, Zeichen, Symbole, Merkmale oder anderen spielbestimmenden Eigenschaften) und zudem die Möglichkeit bekommen mit ihren Sammelkarten und dem Lesegerät auf dem PC, einer Konsole oder einem Handy zu spielen. Das bedeutet, dass sie durch die Installation eines Spiels oder durch das Aufrufen einer Website mit einem integrierten Spiel einen offline oder online Zugang zu einer virtuellen Welt erhalten, in der Sie mit ihren Karten und dem angeschlossenen Lesegerät jegliche Art von Aktionen auslösen können.

So können sie z.B. ihre Karten in einem Online Sammelalbum sammeln und auch im Internet freischalten, sodass jeder ihrer Freunde sehen kann, welche Karten sie haben. Außerdem können sie ihre Karten real tauschen und sobald ihre Karte von einem anderen verwendet wird, verschwindet sie aus dem Sammelalbum und erscheint im Sammelalbum des neuen Besitzers. Des Weiteren können sie mit ihren Karten ein Computerspiel steuern in dem sie die richtige Karten zur richtigen Zeit in das mit dem Computer, der Konsole oder dem Handy verbundene Lesegerät stecken. Zudem haben sie auch die Möglichkeit, direkt gegen ihre Freunde, andere reale Gegner oder virtuelle Gegner im Internet zu spielen. Dafür starten sie das Onlinespiel und stellen sich für einen Onlinewettkampf zur Verfügung. Dadurch lassen sich ganze Turniere, die bisher in größeren Lokalitäten mit physisch anwesenden Kindern stattgefunden haben, sehr einfach in der virtuellen Welt durchführen. So sparen sich die Hersteller der Spiele den Aufwand für die Organisation und die Spieler den Aufwand zu reisen. Doch dafür ist es notwendig, dass die Karten nicht kopierbar sind. Denn bisher wurden auf den Turnieren die Echtheit der Karten anhand des Aussehens und den Sicherheitsmerkmalen geprüft. Sobald die Kinder jedoch online Spielen, können die Karten durch die Schiedsrichter nicht mehr kontrolliert werden. So muss und wird bei dem hier beschriebenen System auf die Nicht-Kopierbarkeit viel Wert gelegt.

Durch die eineindeutige Identifikationsmöglichkeit jeder einzelnen sich im Umlauf befindlichen Karte entstehen weitere interessante Möglichkeiten für die Verwendung der Karten. So kann nun durch den Computer, die Konsole oder das Handy die Geschichte zu jeder Karte in einer zentralen online Datenbank gespeichert werden. Dadurch wird registriert, wie oft eine Karte gewonnen oder verloren hat bzw. wie oft sie verwendet wurde oder wer sie bis jetzt alles besessen hat. Man kann auch festhalten in welchen Städten oder Ländern die Karte bisher war. Dabei entwickelt die Karte einen virtuellen Wert, der sich je nach Spielkonzept auf das Spiel positiv oder negativ auswirken kann. Motivationspunkte können auf diesem Wege gesammelt werden, Siegesserien werden festgehalten und wirken sich auf das Spiel aus. So ist es möglich jeder realen Karte einen virtuellen Wert zu zuordnen, der dann auf dem physischen Weg getauscht oder verkauft werden kann. All diese Funktionen eigenen sich perfekt zum Aufbau einer Spielgemeinschaft in der virtuellen Welt.

Nachfolgend sollen beispielhaft der Aufbau und das Layout von Datenträgern und deren Informationsschichten aufgeführt werden ohne auf diese begrenzt zu sein.

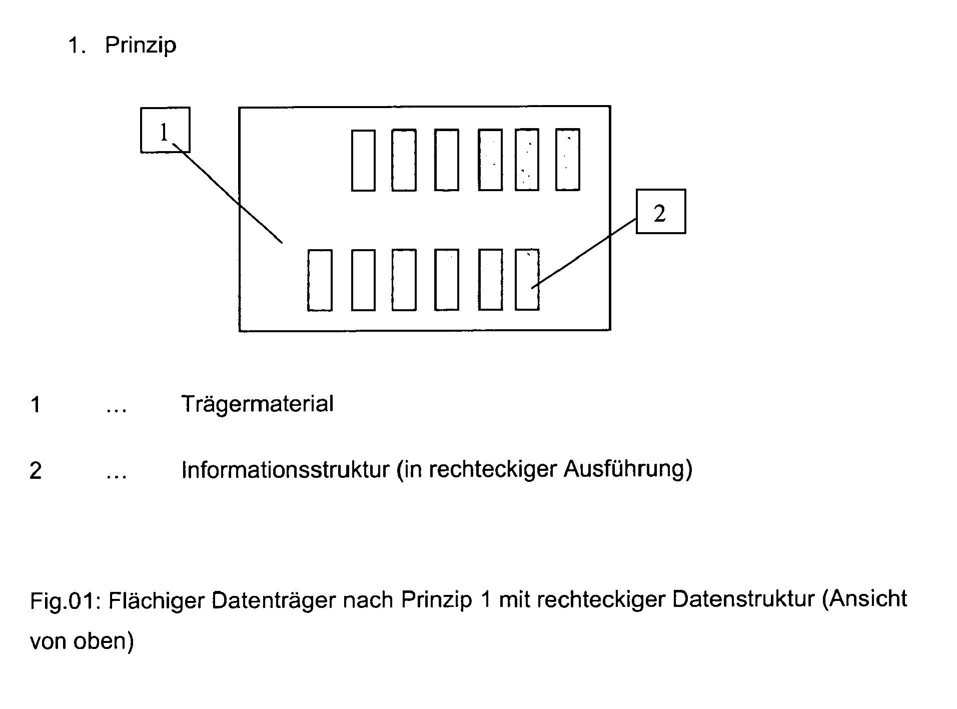

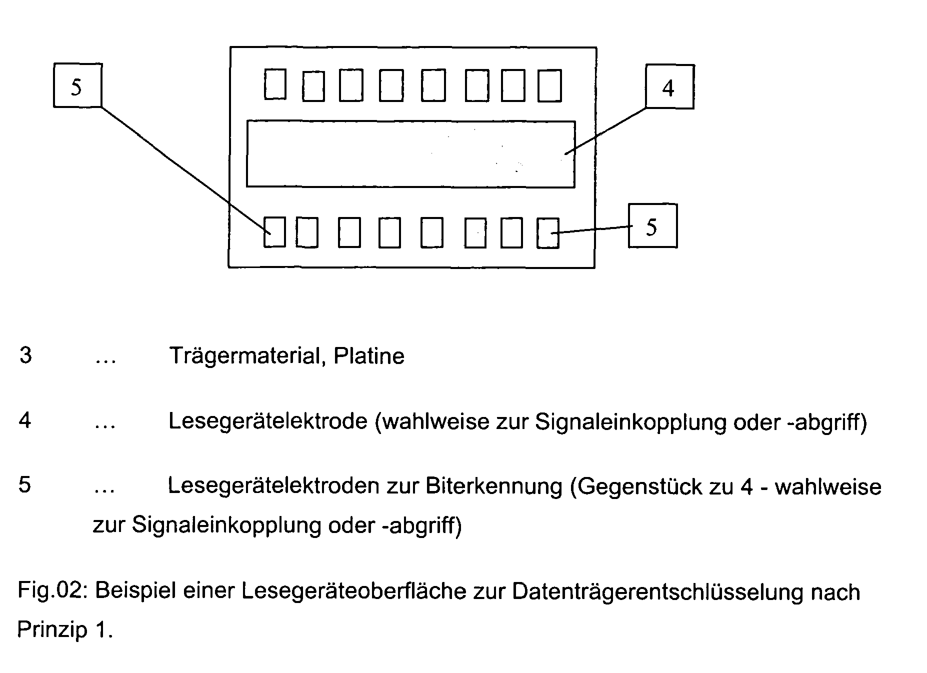

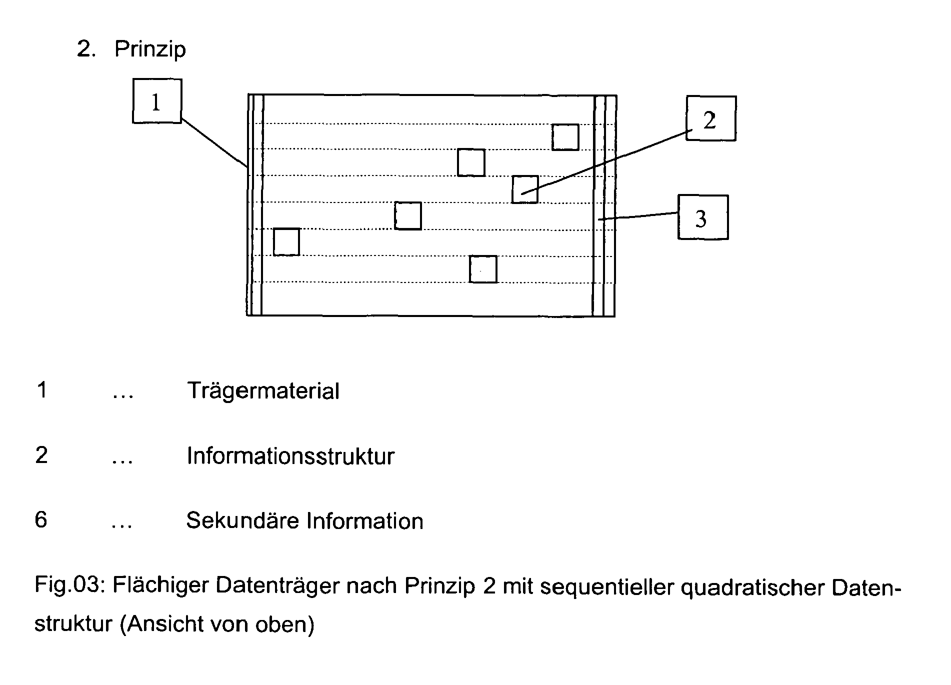

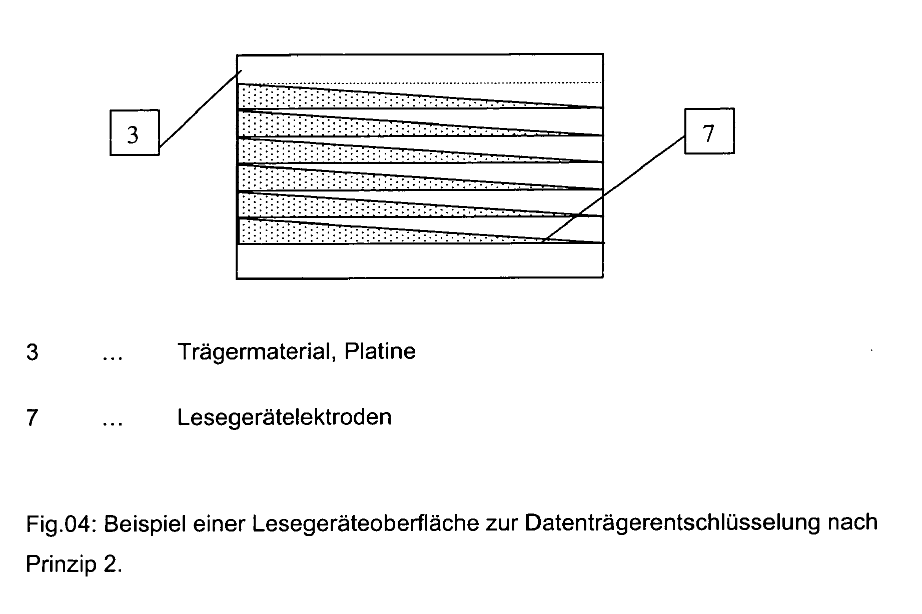

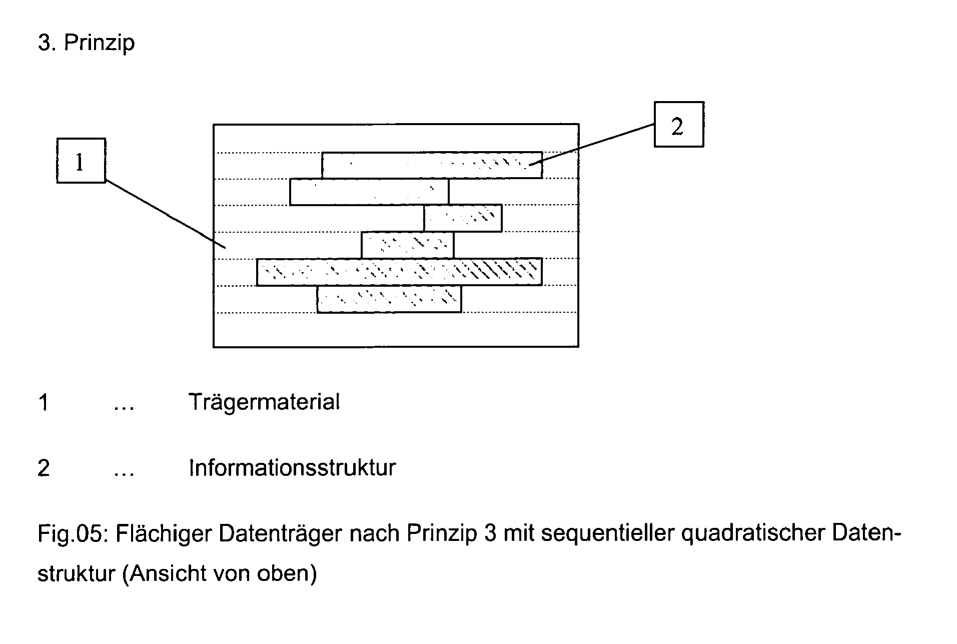

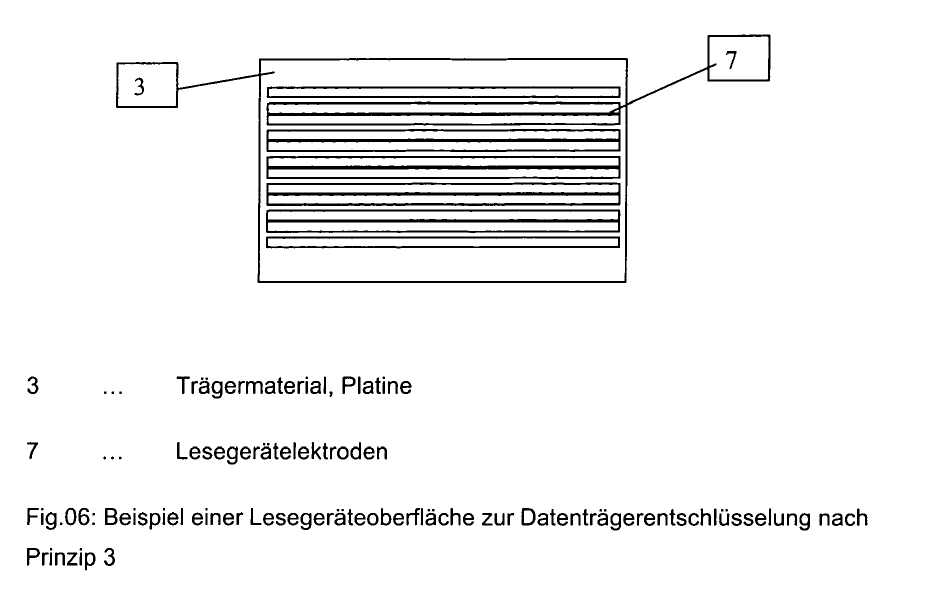

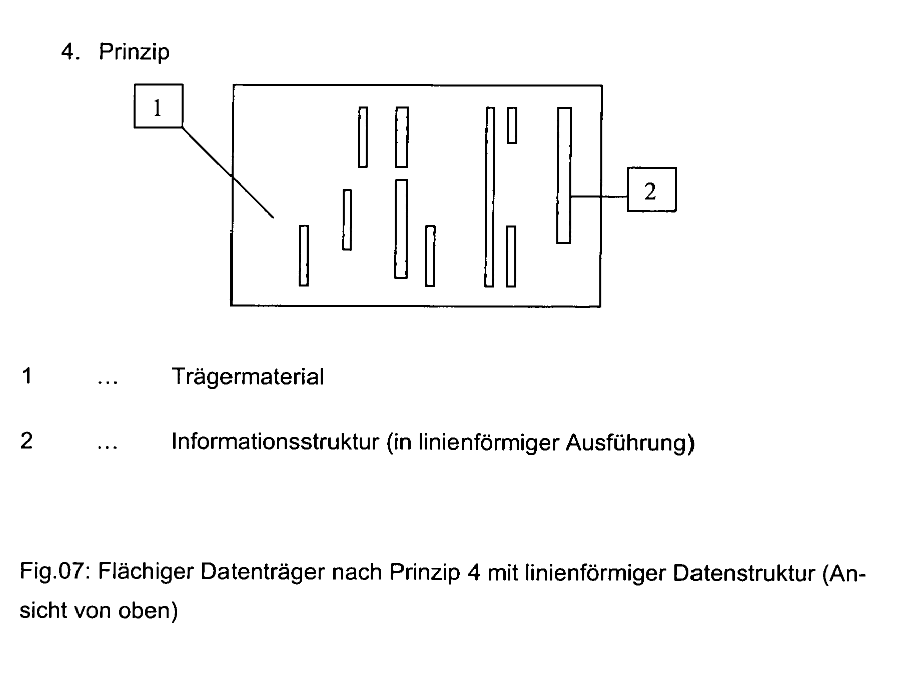

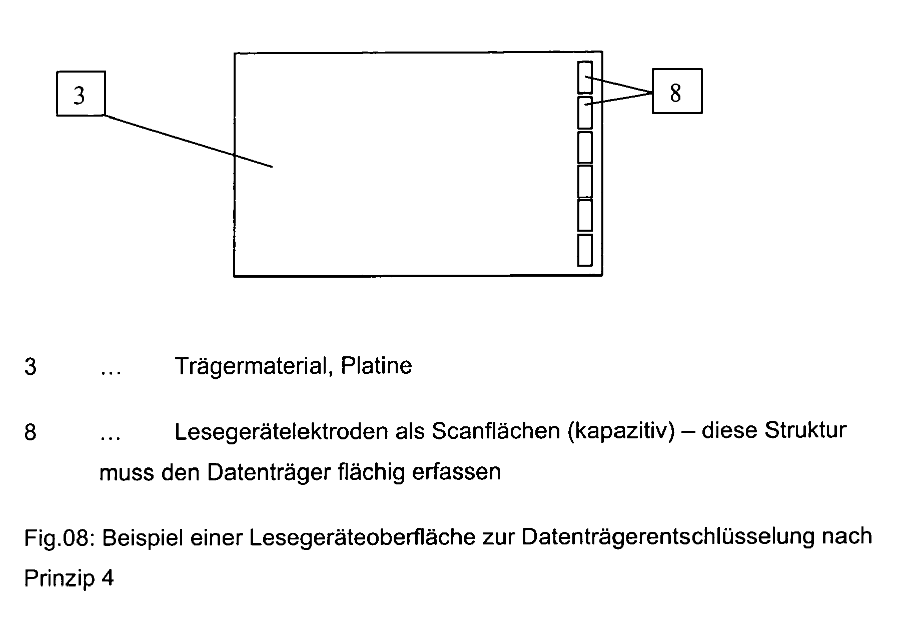

### Beispiele zur Herstellung eineindeutiger Codes:

### Beispiel 1, Kombination eines additiven mit mindestens einem subtraktiven Verfahren:

In einem bildgebenden additiven Verfahren (bspw. Druckmaschine mit Kaltfolientransfermodul) wird eine informationsabbildende Struktur aufgebracht welche einen Datenrohling darstellt (Fig.09)

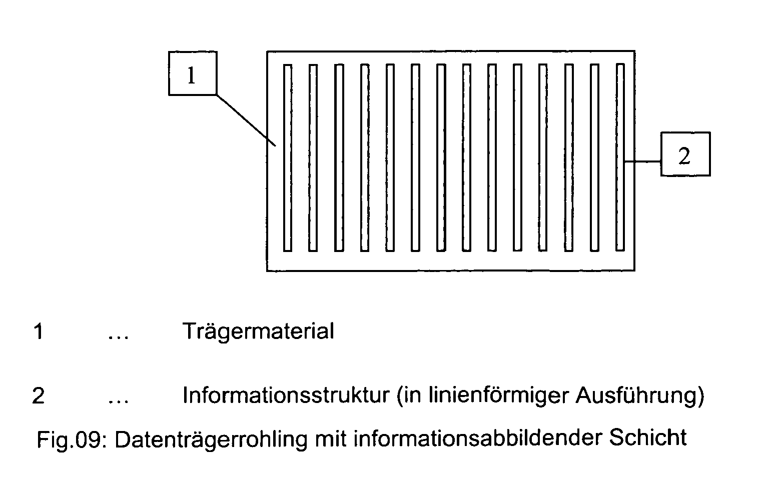

Dieser Datenträgerrohling wird im nächsten Verfahrensschritt individualisiert und erhält somit eine eineindeutige informationsabbildende Schicht, welche ebenso eineindeutig ausgelesen werden kann. Diese Individualisierung kann mittels eines oder mehrerer subtraktiven Verfahrens realisiert werden, bspw. durch Anwendung optischer (z.B. Laser), mechanischer (z.B. Stanzen, Lochen, Schneiden, Wasserstrahlschneiden), elektrischer (Widerstandserhitzen, elektrostatische Entladung) oder thermischer Verfahren (Brennen, Löten). Die so entfernten bzw. zerstörten Bereiche des Datenrohlings sind zumindest derart beeinträchtigt, dass sie nicht mehr als gleichartige (kapazitive) Flächen erkannt werden. Diese Vorgehensweise kann auf alle dargestellten Prinzipien der Informationsabbildung angewandt werden. Bei der Individualisierung soll dagegen das Trägermaterial wenig bis gar nicht beeinträchtigt werden. Hauptziel ist die Bearbeitung der informationsabbildenden Schicht. Alle weiteren Datenträgerrohlinge unterscheiden sich in mindestens einer Position voneinander um eine eineindeutige Information darzustellen. Bei der Darstellung von eindeutigen Informationen ist dies nicht notwendig. Es können dort auch gleichartig bearbeitete Datenträger existieren.

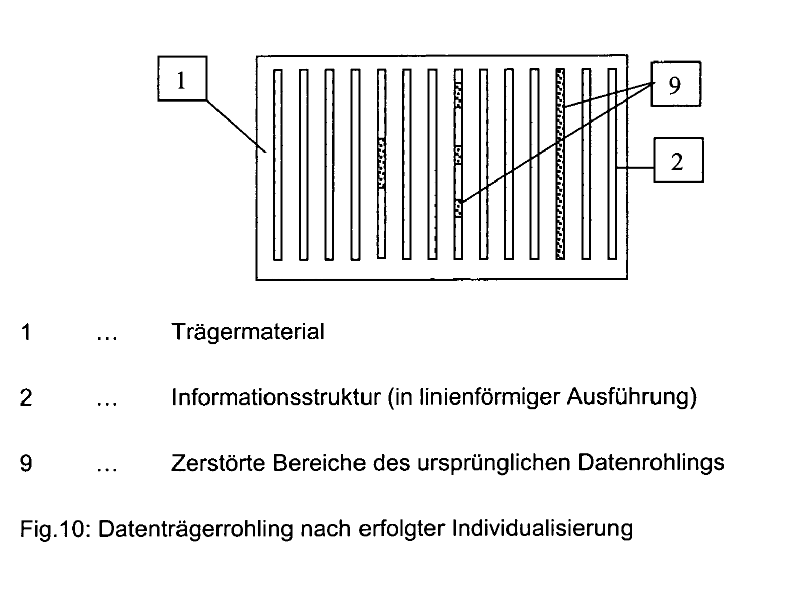

### Beispiel 2, Kombination eines additiven mit mindestens einem weiteren additiven Verfahren:

In einem bildgebenden additiven Verfahren (bspw. Siebdruckmaschine oder Druckmaschine mit Kaltfolientransfermodul) wird eine informationsabbildende Struktur aufgebracht welche einen Datenrohling darstellt (Fig.11).

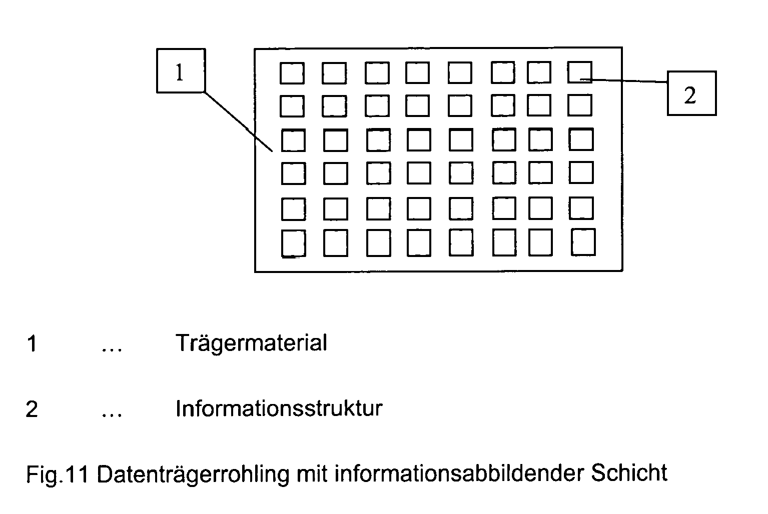

Der Datenrohling wird in einem weiteren Verfahrensschritt individualisiert, indem er mittels mindestens eines weiteren Additivverfahren bearbeitet wird und so bspw. kapazitive Flächen vergrößert, verbindet oder brückt. Dabei gibt es keinerlei Beschränkungen hinsichtlich der Form oder Anordnung der zusätzlich erzeugten Bereiche. Dieses Additivverfahren ist vorzugsweise ein digitales Verfahren und kann dementsprechend individualisierte Datenträger großvolumig herstellen.

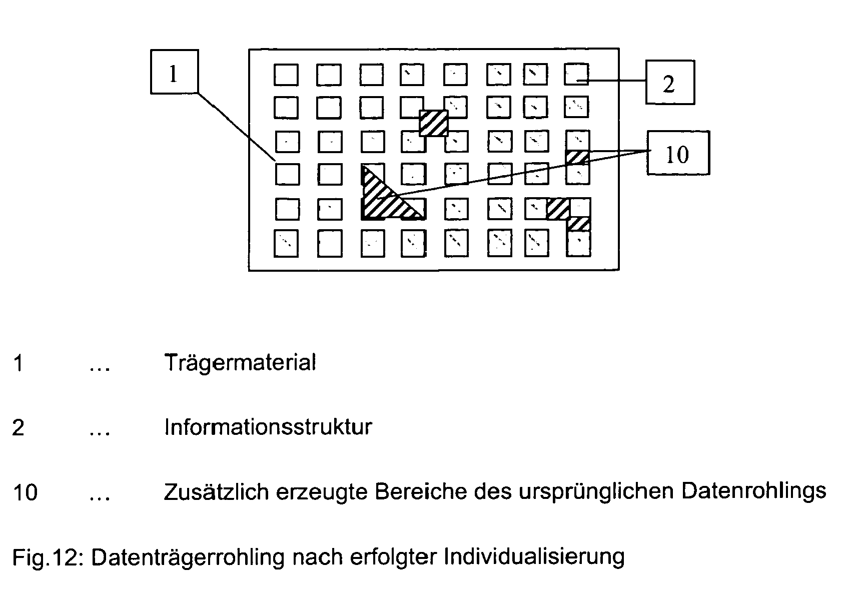

Als Beispiel für die Verwendung von 2 zusätzlichen Additivverfahren sei das Kaltfolienverfahren erwähnt. Dabei kann der Kleber beispielsweise digital auf das Datenträgermedium und/oder die Kaltfolie selbst aufgetragen sein. Durch Kontakt des Datenträgers mit Kleber und der Kaltfolie bzw. des Datenträgers mit der partiell klebend ausgerüsteten Kaltfolie kommt es zur weiteren Abbildung der informationsabbildenden Schicht (10). Die so erzeugten Strukturen stellen den individualisierten Datenträger dar. Diese Vorgehensweise kann auf alle dargestellten Prinzipien der Informationsabbildung angewandt werden.

### Beispiel 3, direkte Informationsabbildung im Additivverfahren:

In einem weiteren Ausführungsbeispiel können die eineindeutigen Datenträger auch in mind. einem Additivverfahren hergestellt werden. Als Beispiele für rein additive Verfahren gelten Digitaldruck-, Sprüh-, Inkjet-, Stempeldruck-, Präge-, Heißpräge oder Dispensverfahren. In jedem Fall wird zumindest partiell eine Beschichtung mit der informationsabbildenden Schicht auf dem Trägermaterial vorgenommen. Die Materialien für die informationsabbildenden Schichten gehören zu den vorgenannten Materialien und Materialgruppen.

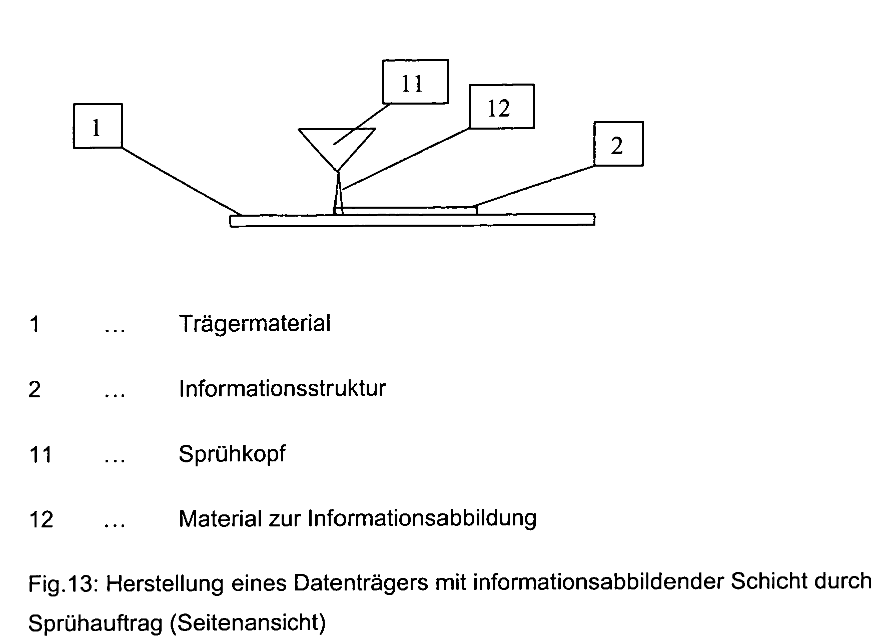

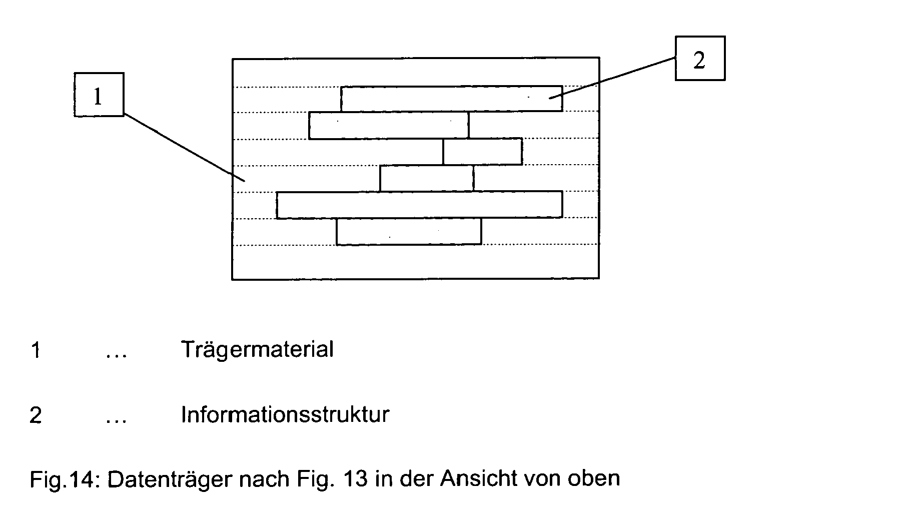

Je nach angewandtem Verfahren können weitere Verfahrensschritte folgen. Solche Verfahrensschritte sind z.B. Trocknungsprozesse, Härtungsprozesse und Druckprozesse.

### Beispiel 4, direkte Informationsabbildung im Subtraktivverfahren:

Rein subtraktive Verfahren setzen eine vollflächige bzw. partielle Bedeckung mit der informationsabbildenden Schicht voraus, welche dann ebenfalls vollflächig, aber zumindest partiell entfernt und/oder zerstört wird. Solche Verfahren sind beispielsweise Ätzen, Stanzen, Lochen, Schneiden, Schneidplotten und Laserverfahren.

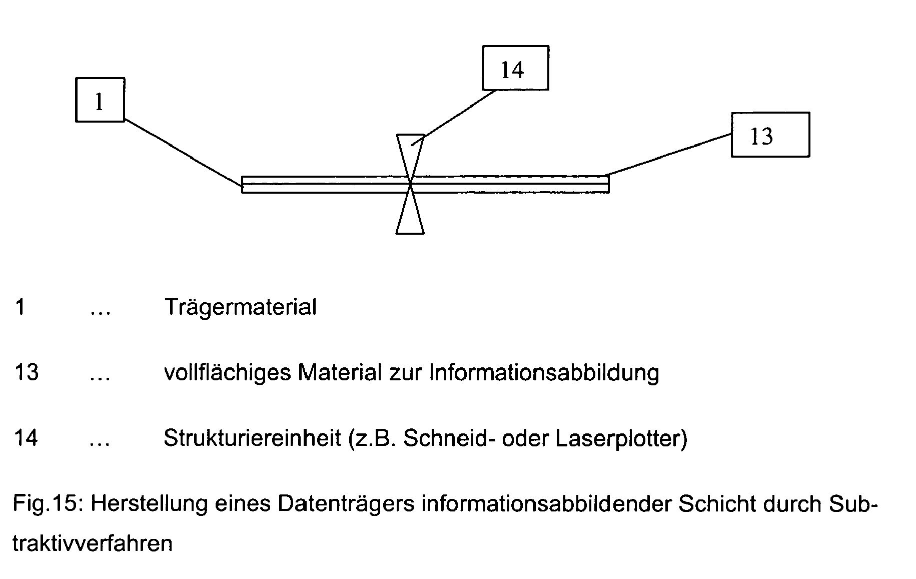

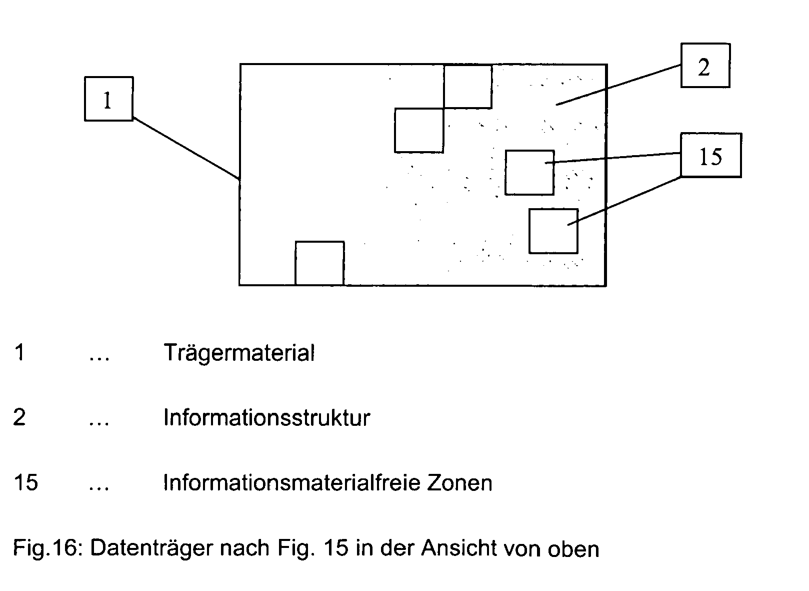

Die Entstehung von Durchbrüchen und/oder Löchern im Trägermaterial (1) ist nicht funktionsnotwendig und kommt je nach subtraktiven Herstellungsverfahren mehr, weniger oder gar nicht vor.

Je nach angewandtem Verfahren können weitere Verfahrensschritte folgen. Solche Verfahrensschritte sind z.B. Bürsten, Absaugen und Druckprozesse.

## Patentansprüche

1. Datenträger,
**dadurch gekennzeichnet, dass**
auf einem elektrisch nicht leitenden Substrat eine Kleberschicht, eine strukturierte, mindestens einlagige Informationsschicht und wenigstens eine zumindest einen Bereich des Substrates mit der strukturierten Informationsschicht überdeckenden weiteren Schicht angeordnet ist, wobei die Informationsschicht eine aufgebrachte Transferschicht und mindestens ein Bereich der strukturierten Informationsschicht gleichzeitig ein Geber für eine kapazitive Leseeinrichtung ist.

2. Datenträger nach dem vorhergehenden Anspruch,
**dadurch gekennzeichnet, dass**
die Informationsschicht Metalle, Graphit, Ruß und/oder dielektrische Werkstoffe umfasst und/oder die weiteren Schichten, eine Kleberschicht, eine Papierschicht und/oder eine Farbschicht umfassen.

3. Datenträger nach einem der vorhergehenden Ansprüche,
**dadurch gekennzeichnet, dass**
auf dem elektrisch nicht leitenden Substrat eine klebende Transferschicht aufgebracht vorliegt.

4. Datenträger nach einem der vorhergehenden Ansprüche,
**dadurch gekennzeichnet, dass**
nicht das Transfermaterial, sondern bevorzugt der Kleber strukturiert ist.

5. Datenträger nach einem der vorhergehenden Ansprüche,
**dadurch gekennzeichnet, dass**
eine Farbschicht jeweils wenigstens als Hintergrund, Überdeckung, Zahl, Buchstabe, Zeichen, graphische Darstellung, bildliche Darstellung oder wenigstens eine Kombination hiervon aufgebracht ist, wobei
- mehrere Datenträger eine gleiche Struktur der Informationsschicht und mindestens eine gleich oder ungleich gestaltete Farbschicht besitzen, so dass eine Gruppe eindeutiger Datenträger realisiert ist, oder
- mehrere Datenträger eine ungleiche Struktur der Informationsschicht und gleich oder ungleich gestaltete Farbschichten besitzen, so dass eine Gruppe eineindeutiger Datenträger realisiert ist.

6. Datenträger nach einem der vorhergehenden Ansprüche,
**dadurch gekennzeichnet, dass**
die Strukturen aus geometrischen Formen, insbesondere Rechtecken, Kreisen und/oder einer Kombination hiervon und/oder geographisch unbestimmten Formen, insbesondere Freihandformen, zufällig und/oder pseudozufällig erzeugter Strukturen besteht, so dass die Position und/oder sowohl die Position als auch die Formen und Flächen der Strukturen oder nur die Formen und Flächen der Strukturen mittels der Leseeinrichtung feststellbar sind, so dass die Struktur ein Code einer bestimmten Anzahl von Datenträgern ist.

7. Datenträger nach einem der vorhergehenden Ansprüche,
**dadurch gekennzeichnet, dass**
die Struktur eine additive Struktur oder eine sowohl additiv aufgebrachte als auch subtraktiv veränderte Struktur ist.

8. Datenträger nach einem der vorhergehenden Ansprüche,
**dadurch gekennzeichnet, dass**
das Substrat, Papier, Karton, Holzwerkstoffe, Verbundwerkstoffe, Laminate und/oder Kunststoffe umfasst.

9. Datenträger nach einem der vorhergehenden Ansprüche,
**dadurch gekennzeichnet, dass**
der Datenträger Teil eines Druckproduktes ist, bevorzugt einer Verpackung.

10. Datenträger nach einem der vorhergehenden Ansprüche,
**dadurch gekennzeichnet, dass**
auf den Datenträger weitere optische, elektrische, sensorische und/oder akustische Elemente aufgebracht sind.

11. Datenträger nach einem der vorhergehenden Ansprüche,
**dadurch gekennzeichnet, dass**
auf den Datenträger sekundäre Informationen aufgebracht oder enthalten sein können, welche insbesondere die Orientierung des Datenträgers relativ zur Leseeinrichtung bestimmbar machen.

12. Datenträger nach einem der vorhergehenden Ansprüche,
**dadurch gekennzeichnet, dass**
Informationen auf- oder angebracht werden, welche übergeordnete Funktionen wahrnehmen, insbesondere aufgedruckte Werte, Symbole, Zeichen, Sicherheits- und oder Echtheitsmerkmale, insbesondere auf Spielkarten und/oder Sammelkarten.

13. Datenträger nach einem der vorhergehenden Ansprüche,
**dadurch gekennzeichnet, dass**
der Datenträger in seiner Verwendung durch mindestens ein Datenverarbeitungssystem virtuell weiter individualisiert und/oder personalisiert wird.

14. Datenträger nach einem der vorhergehenden Ansprüche,
**dadurch gekennzeichnet, dass**
dass dieser einen virtuellen Wert repräsentieren und dieser konstant oder im Laufe seiner Verwendung zu- oder abnehmen kann.

15. Datenträger nach einem der vorhergehenden Ansprüche,
**dadurch gekennzeichnet, dass**
die Datenträger als Spielkarten, Sammelkarten, Briefmarken, Frankierung, Porto, Warenlogistik, Warenverfolgung, Einlass, Eintrittskarten, Zugang zu geschlossen Bereichen, virtuellen Inhalten, Marketinganwendungen, Kundenbindung, Mitgliederausweise, Zeitkarten, Paymentanwendungen, (Echtheits-) Zertifikate, Signaturen, Lieferscheine, Virtual Items, Music/Video/E-Books-Downloads, Bonusmarken/-programme oder Geschenkkarten verwendet werden.

16. Datenträger nach einem der vorhergehenden Ansprüche,
**dadurch gekennzeichnet, dass**
nur in Kombination mit mindestens einem weiteren Datenträger der Informationsgehalt komplettiert wird.

17. Datenträger nach einem der vorhergehenden Ansprüche,
**dadurch gekennzeichnet, dass**
die informationsabbildende Schicht auch das Trägermaterial beinhaltet und/oder das Trägermaterial der informationsabbildenden Schicht gleich dem späteren Trägermaterial des Datenträgers ist.

18. Datenverarbeitungssystem mit einer Leseeinrichtung und einem Datenträger nach einem der Ansprüche 1 bis 17,
**dadurch gekennzeichnet, dass**
die Leseeinrichtung mindestens mehrere Leseelektroden aufweist und der Datenträger in der Leseeinrichtung ein Bestandteil der Lesegerätelektrodenanordnungen ist, wobei die Leseeinrichtung mit dem Datenspeicher mit einer Datenverarbeitungseinheit so zusammengeschaltet ist, dass der Datenträger (über die Struktur) Daten eines Speichers zugeordnet ist.

19. Datenverarbeitungssystem nach dem vorhergehenden Anspruch,
**dadurch gekennzeichnet, dass**
die Daten eine oder mehrere Bilddateien entsprechend der gestalteten Farbschicht des Datenträgers sind.

20. Datenverarbeitungssystem nach einem der vorhergehenden Ansprüche,
**dadurch gekennzeichnet, dass**
der Datenträger ein Schlüssel für ein Datenverarbeitungssystem oder wenigstens ein mit dem Datenverarbeitungssystem verbundenes weiteres Datenverarbeitungssystem ist, so dass der Zugang zu weiteren Daten und/oder einer Kombination gegeben ist.

21. Datenverarbeitungssystem nach einem der vorhergehenden Ansprüche,
**dadurch gekennzeichnet, dass**
die Leseeinrichtung entweder ein Schacht, ein Schlitz und/oder eine Auflagefläche zur Aufnahme wenigstens eines Teils des Datenträgers besitzt und der Datenträger vorgegeben und/oder zufällig in, an oder auf der Leseeinrichtung positioniert ist.

22. Datenverarbeitungssystem nach einem der vorhergehenden Ansprüche,
**dadurch gekennzeichnet, dass**
die Elektrodenanordnungen der Leseeinrichtungen so ausgebildet und angeordnet sind, dass die Anzahl und/oder Größe und/oder Form der Bestandteile der Struktur des Datenträgers erfasst werden.
